**Europäisches Patentamt**

**European Patent Office**

**Office européen des brevets**

(19)

(11) Veröffentlichungsnummer : **0 508 290 B1**

(12)

# EUROPÄISCHE PATENTSCHRIFT

(45) Veröffentlichungstag der Patentschrift :
**19.07.95 Patentblatt 95/29**

(51) Int. Cl.⁶ : **G01R 15/00**, G01R 31/28,
G01S 3/00

(21) Anmeldenummer : **92105590.1**

(22) Anmeldetag : **01.04.92**

(54) **Einrichtung zum Einstellen einzelner unterschiedlicher elektronischer Geräte eines Gerätesystems.**

(30) Priorität : **06.04.91 DE 4111181**

(43) Veröffentlichungstag der Anmeldung :
**14.10.92 Patentblatt 92/42**

(45) Bekanntmachung des Hinweises auf die
Patenterteilung :
**19.07.95 Patentblatt 95/29**

(84) Benannte Vertragsstaaten :
**DE FR GB IT**

(56) Entgegenhaltungen :
**EP-A- 0 295 760
EP-A- 0 324 600
ELECTRO /86 AND MINI/MICRO NORTHHE-
AST CONF. RECORD Bd. 11, Nr. 8/5, Mai 1986,
LOS ANGELES US Seiten 1 - 6; J.J.TRUCHARD
ET AL.: 'Graphical Programming Tools
for Instrumentation'**

(56) Entgegenhaltungen :
**ELEKTRONIK. Bd. 36, Nr. 18, September 1987,
MUNCHEN DE Seiten 92 - 94; H. QUAKU-
LINSKY: 'Programmieren mit Menüs und Formularen'
ELEKTRONIK. Bd. 38, Nr. 20, September 1989,
MUNCHEN DE Seiten 102 - 110; A. PREUSS:
'Die Klaviatur der Messtechnik'
ELEKTRONIK. Bd. 38, Nr. 20, September 1989,
MUNCHEN DE Seiten 112 - 115; A. KUHN:
'Labormessaufbau am PC-Bildschirm'**

(73) Patentinhaber : **Rohde & Schwarz GmbH & Co.
KG
Mühldorfstrasse 15
D-81671 München (DE)**

(72) Erfinder : **Horn, Wolfgang
Ampfingstrasse 44
W-8000 München 80 (DE)**

(74) Vertreter : **Graf, Walter, Dipl.-Ing.
Sckellstrasse 1
D-81667 München (DE)**

Anmerkung : Innerhalb von neun Monaten nach der Bekanntmachung des Hinweises auf die Erteilung
des europäischen Patents kann jedermann beim Europäischen Patentamt gegen das erteilte europäische Patent Einspruch einlegen. Der Einspruch ist schriftlich einzureichen und zu begründen. Er gilt
erst als eingelegt, wenn die Einspruchsgebühr entrichtet worden ist (Art. 99(1) Europäisches Patentübereinkommen).

## Beschreibung

Auf den verschiedensten Gebieten der Technik werden immer mehr eine Vielzahl von verschiedenen elektronischen Geräten zu einem Gesamtsystem zusammengestellt, durch das die verschiedenartigsten Erfassungs- oder Meßaufgaben gelöst werden können. So werden in der Funkerfassung beispielsweise Gerätesysteme benutzt, bei denen mehrere unterschiedliche Funkpeiler, die auf unterschiedlichen Frequenzen und nach unterschiedlichen Prinzipien arbeiten, mit Suchempfängern und Abhörempfängern kombiniert sind. Mit einem solchen universellen Funkerfassungssystem können die verschiedenartigsten Funkerfassung-Aufgaben gelöst werden. In der elektronischen Meßtechnik ist es beispielsweise üblich, die verschiedenartigsten elektronischen Meßgeräte an einem Meßplatz zu kombinieren, beispielsweise Spannungsmesser, Strommesser, Generatoren, Analysatoren und dergleichen, so daß mit einem solchen universellen Meßplatz die unterschiedlichsten Meßobjekte gemessen werden können. All diesen Systemen ist der Nachteil gemeinsam, daß der Benutzer bei der Auswahl und beim Einstellen der immer komplizierter werdenden elektronischen Geräte überfordert ist.

Um die Einstellung einzelner elektronischer Meßgeräte zu erleichtern ist es bekannt, hierfür einen Steuerrechner einzusetzen, der dem Benutzer anzeigt, welche verschiedenen Meßmöglichkeiten das Meßgerät bietet und wie diese Meßmöglichkeiten vom Benutzer am Meßgerät eingestellt werden müssen (DE 32 08 136). Damit wird die Bedienung solcher Meßgeräte zwar vereinfacht, der Benutzer muß jedoch weiterhin nacheinander an den Meßgeräten entsprechende Einstellungen durchführen, dazu muß er sich für jedes Meßobjekt jeweils die zugehörigen zu messenden Meßparameter und Darstellungsarten erarbeiten.

Im Zusammenhang mit solchen sogenannten PC-Meßgeräten ist es ferner bekannt, mehrere solche Meßgeräte zu einem automatischen Meßplatz zusammenzustellen und über einen Steuerrechner zu steuern (Elektronik, Bd. 38 Nr. 20 (1989), S. 102-110). Dem Steuerrechner ist hierbei auch noch ein Gerätespeicher zugeordnet, in welchem die Daten der einzelnen Geräte des Systems mit ihren technischen Eigenschaften und ihren einstellbaren Funktionen gespeichert sind. Bei diesem bekannten System werden dem Benutzer zwar die im System zur Verfügung stehenden verschiedenen Meßgeräte vorgestellt, welche davon er jedoch für eine bestimmte Meßaufgabe benutzen soll muß sich der Benutzer auch hier selbst aussuchen, auch die Einstellung der Meßgeräte muß auch bei diesem System vom Benutzer ausgewählt und vorgenommen werden.

Es ist daher Aufgabe der Erfindung, eine Einrichtung zu schaffen, mit der auch ungeübte Benutzer ein solches System von mehreren unterschiedlichen elektronischen Geräten für eine bestimmte Aufgabe auf einfache Weise einstellen können.

Diese Aufgabe wird erfindungsgemäß durch eine Einrichtung laut Hauptanspruch gelöst. Vorteilhafte Weiterbildungen ergeben sich aus den Unteransprüchen.

Mit einer erfindungsgemäßen Einrichtung können auch ungeübte Benutzer komplizierte Systeme von elektronischen Geräten auf einfache Weise richtig einstellen, ohne daß der Benutzer Einzelheiten der Geräte und deren Einstellmöglichkeiten kennt. Dazu ist es nur erforderlich, einen zusätzlichen Objekt-Speicher vorzusehen, in welchem die verschiedenen Objekttypen mit ihren Eigenschaften gespeichert sind, wie dies für Funkgeräte an sich bekannt ist (Elektronik, Bd. 36, Nr. 18 (1987) S. 92-94). Für die Bedienung und Einstellung einer erfindungsgemäßen Einrichtung muß der Benutzer nur seine von ihm gewünschten Ergebnisse kennen, alles weitere wird dann selbsttätig von der Einrichtung durchgeführt. So braucht sich beispielsweise der Benutzer eines Funkerfassungssystems nur bildhaft eine Spektrumdarstellung (Panoramadarstellung) vorstellen, die ihm die Belegung eines Frequenzbandes mit Sendern eines bestimmten Typs darstellt. Dazu stellt sich der Benutzer möglicherweise noch eine Karte einer vorbestimmten Gegend mit den eingezeichneten Orten dieser Sender vor. Der Benutzer braucht dann nur noch aus den ihm angebotenen Darstellungsarten die Panoramadarstellung und das Ortungsergebnis auswählen, die erfindungsgemäße Einrichtung stellt dann selbsttätig die Geräte des Funkerfassungssystems entsprechend ein. In gleicher Weise stellt sich beispielsweise ein Meßtechniker schon vorher den von ihm gewünschten Meßbericht mit bestimmten Diagrammen über den Verlauf von Dämpfung und Gruppenlaufzeit in einem bestimmten Frequenzbereich bildhaft vor, bevor er ein bestimmtes Meßobjekt einem Meßsystem mit unterschiedlichen elektronischen Meßgeräten zuführt. Auch in diesem Fall braucht der Meßtechniker also nur seine Meßergebnis-Wünsche in die Einrichtung eingeben, die Einrichtung stellt dann wieder vollständig selbsttätig die für dieses Meßergebnis erforderlichen Meßgeräte ein, führt dann die Messung automatisch aus und liefert schließlich das gewünschte Meßergebnis. Es ist auch möglich, daß ein Meßtechniker vor Beginn einer Messung auf dem Bildschirm sein gewünschtes Diagramm oder auch mehrere solche Diagramme selbst darstellt, die jeweiligen Koordinatenachsen mit den entsprechenden Parametern beschriftet und auf die interessierenden Parameterbereiche skaliert. Dies wird erleichtert, wenn der Meßtechniker den von ihm zu messenden Meßobjekttyp eingibt und damit die Einrichtung ihm diese Arbeit abnimmt. Dadurch wird die Umsetzung einer bestimmten Meßergebnis-Vorstellung in die Auswahl der richtigen Meßgeräte und deren jeweils richtige Einstellung auch bei extrem komplexen Meßsystemen mit zahlreichen Meßfunktionen sehr einfach, da der Benutzer nichts Näheres über die Meßgeräte und deren Funktionen wissen muß. Eine erfindungsgemäße Einrichtung erleichtert daher die Bedienung von komplizierten Gerätesystemen erheblich, auch die Einstellzeiten können dadurch erheblich verringert werden. Die erfindungsgemäße Einrichtung ist nicht nur für Funkerfassungssysteme oder Meßsysteme geeignet, sondern in analoger Weise mit gleichem Vorteil auch zum Einstellen einzelner elektronischer Geräte eines Gesamtgerätesystems für beliebige Meß- oder Erfassungs-Aufgaben an beliebigen Objekten.

Eine erfindungsgemäße Einrichtung kann in der Praxis relativ einfach realisiert werden, da die meisten elektronischen Geräte entsprechende Anschlüsse für eine Fernbedienung aufweisen, so weisen beispielsweise alle Geräte wie Peiler, Suchempfänger und dergleichen für die Funkerfassung neben den frontseitigen Einstelleinrichtungen rückseitige Anschlüsse für eine Fernbedienung auf, entsprechendes gilt für moderne elektronische Meßgeräte, die ebenfalls entsprechende Fernbedienungsanschlüsse besitzen. Es ist daher nur noch erforderlich, diese Fernbedienungsanschlüsse der elektronischen Geräte mit dem Steuerrechner entsprechend zu verknüpfen, so daß der Steuerrechner die gewünschten Einstellungen an den Geräten selbsttätig durchführen kann. Das erfindungsgemäße Prinzip kann dabei nicht nur bei Systemen angewendet werden, die aus einzelnen elektronischen Geräten zusammengestellt sind, es kann in gleicher Weise auch bei Gerätesystemen angewendet werden, die in einem Gerät integriert die verschiedenartigsten Erfassungs- oder Meßaufgaben lösen können, also beispielsweise komplizierte Funkerfassungsgeräte oder Meßgeräte, die auf verschiedenartigste Betriebsarten umschaltbar sind.

Die Erfindung wird im folgenden anhand schematischer Zeichnungen an mehreren Ausführungsbeispielen näher erläutert.

Fig. 1 bis 6 zeigen eine erfindungsgemäße Einrichtung angewendet bei einem Funkerfassungssystem.

Fig. 7 bis 13 zeigen die Anwendung einer erfindungsgemäßen Einrichtung bei einem elektronischen Meßsystem.

Fig. 14 zeigt die Anwendung bei einem Funkpeiler.

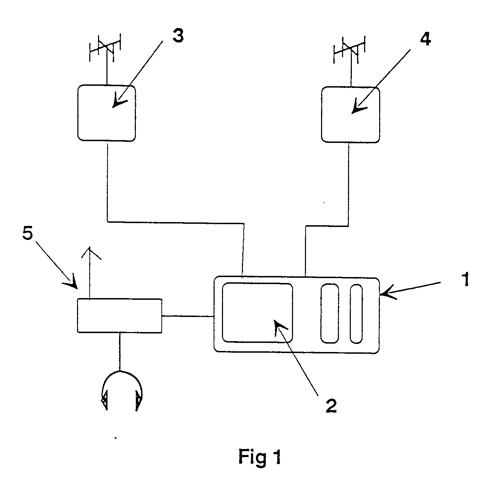

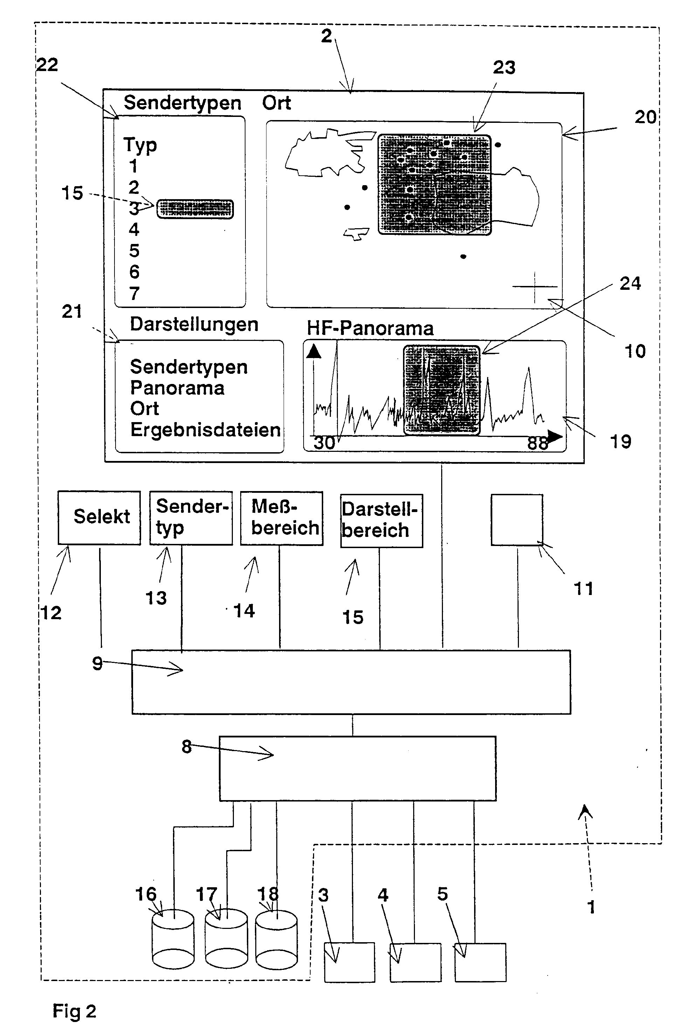

Fig. 1 zeigt den Prinzipaufbau eines Funkerfassungssystems bestehend aus mehreren Funkpeilern 3 und 4 sowie einem Mithörempfänger 5. Diese elektronischen Geräte 3 bis 5 sind mit einem Steuerrechner 1 funktionsmäßig verknüpft und fernsteuerbar. Der Steuerrechner weist eine übliche Benutzeroberfläche mit einem Bildschirm 2 auf, Einzelheiten ergeben sich aus Fig. 2. Das Steuerprogramm 8 des Rechners 1 verwendet eine grafische, fensterorientierte Benutzeroberfläche 9, wie sie für Rechner heute üblich ist, um dem Benutzer Informationen zu präsentieren und Informationen und Entscheidungen von ihm einzuholen.

Diese Fenster lassen sich öffnen, indem der Nutzer in der Tabelle ein Feld in der Zeile mit dem Namen des Fensters anklickt, woraufhin ihm das Steuerprogramm 8 dieses Darstellfeld präsentiert. Sie lassen sich gleichzeitig auch aktivieren zur Ausgabe aktueller Meßergebnisse, indem der Nutzer den Cursor auf dem Rahmen des Fensters positioniert und die Taste "Darstellbereich" betätigt. Gleichzeitig oder alternativ lassen sie sich auch zur Darstellung älterer Meßergebnisse verwenden.

Dem Benutzer bietet die Benutzeroberfläche 8 eine Cursorsteuerung 11, mit der er einen Cursor 10 auf dem Bildschirm bewegen kann. Dieser Cursor, der im Normalzustand auf einen Bildschirmpunkt zeigt, läßt sich auf eine übliche Art "aufspannen", so daß er statt eines Punktes alle Punkte innerhalb einer Umrahmung bezeichnet. Ein Beispiel hierfür zeigt die Fläche 23 in Fig. 2. Grafische Elemente, auf die der Cursor zeigt, lassen sich nun mit den Tasten "Selekt" 12, "Meßbereich" 14, "Darstellbereich" und "Analysebereich" auswählen.

Dem Rechner 1 sind noch drei Speicher 16 bis 18 zugeordnet, nämlich ein Sendertypen-Speicher 16, ein Erfassungsgeräte-Speicher 17 sowie ein Ergebnis-Speicher 18.

Im Erfassungsgeräte-Speicher 17 sind die einzelnen dem System zugeordneten Funkerfassungsgeräte 3 bis 5 mit ihren technischen Daten und ihren einstellbaren Funkerfassungsfunktionen gespeichert, also beispielsweise:

| Erfassungsgerät: | | System | Peiler | Mithör-empfänger |
|---|---|---|---|---|
| Parameter Ortung: | | | | |
| kleinste östliche Länge: | [°] | 8 | | |
| größte östliche Länge: | [°] | 10 | | |
| kleinste nördliche Breite: | [°] | 50 | | |
| größte nördliche Breite: | [°] | 51 | | |
| dazu erforderliche Parameter: | | Azimut Peiler 3 und 4 synchron | | |
| Parameter Frequenz: | | | | |
| kleinste Frequenz: | [MHz] | | 20 | 2 |
| größte Frequenz: | [MHz] | | 200 | 1000 |
| kleinste Auflösung: | [kHz] | | 1 | 0,10 |
| maximale Einstellzeit: | [s] | | 1,00E-3 | 1,00E-2 |
| Bandbreiten: | [kHz] | | 7,50 | 2,70 |
| | | | 15 | 8 |
| | | | 150 | 15 |
| | | | | 250 |
| | | | | 1000 |
| dazu erforderliche Parameter: | | | keine | keine |
| Parameter Pegel: | | | | |
| Modulationsarten: | | | alle | alle |
| Meßzeit: | [s] | | 2,00E-3 | 2,00E-3 |
| dazu erforderliche Parameter: | | | Frequenz | Frequenz |
| Parameter Azimut: | | | | |
| Modulationsarten: | | | alle | |
| Meßzeit: | [s] | | 0,10 | |
| dazu erforderliche Parameter: | | | Frequenz | Frequenz |
| Parameter Inhalt: | | | | |
| Modulationsarten: | | | | AM, FM, USB, LSB |
| Meßzeit: | [s] | | | manuell |
| dazu erforderliche Parameter: | | | Frequenz | Frequenz |

Die Eingabe dieser Daten in den Speicher 17 erfolgt aufgrund der Datenblätter des Herstellers dieser Geräte.

Im Sendertypen-Speicher 16 sind die mit dem Funkerfassungssystem erfaßbaren Sendertypen abgespeichert und zwar zusammen mit ihren erfaßbaren Parametern, also beispielsweise:

```
Meßbare Parameter für alle Sendertypen:
Ort:                              ja
Frequenz:                         ja
Pegel:              .             ja
Azimut:                           ja
Inhalt:                           ja
```

| Sendertyp: | Einheit | Typ 1 | Typ 2 | Typ 3 |
|---|---|---|---|---|
| **Technische Eigenschaften:** | | | | |
| untere Betriebsfrequenz: | [MHz] | 1,50 | 26 | 30 |
| obere Betriebsfrequenz: | [MHz] | 30 | 46 | 88 |
| kleinster Frequenzschritt: | [kHz] | 0,10 | 12,50 | 25 |
| Bandbreiten: | [kHz] | 0,15 | 8 | 8 |
| Modulationsarten: | | AM, USB, LSB | AM, FM | FM, |

| Sendertyp: | | Typ 4 | Typ 5 | Typ 6 |
|---|---|---|---|---|
| **Technische Eigenschaften:** | | | | |
| untere Betriebsfrequenz: | [MHz] | 88 | 116 | 225 |
| obere Betriebsfrequenz: | [MHz] | 107 | 156 | 400 |
| kleinster Frequenzschritt: | [kHz] | 75 | 12,50 | 25 |
| Bandbreiten: | [kHz] | 75 | 8 | 12 |
| Modulationsarten: | | FM | AM | FM, |

| Sendertyp: | | Typ HF | Typ V | Typ U |
|---|---|---|---|---|
| **Technische Eigenschaften:** | | | | |
| untere Betriebsfrequenz: | [MHz] | 2 | 30 | 200 |
| obere Betriebsfrequenz: | [MHz] | 30 | 200 | 1000 |
| kleinster Frequenzschritt: | [kHz] | 0,10 | 12,50 | 12,50 |
| Bandbreiten: | [kHz] | 0,10 | 12,50 | 12,50 |
| Modulationsarten: | | alle | alle | alle |

Die Daten für den Sendertypen-Speicher 16 werden anfänglich aus den Beschreibungen ihrer Hersteller abgeleitet und in die Datei übertragen, sie können aber auch mit Hilfe des Steuerprogramms und der Darstellungen erzeugt werden, indem der Benutzer z.B. in einer beliebigen Darstellung "Panorama" 19 mit dem Cursor 10 auf übliche Art und Weise einen Parameterbereich 24 definiert und die Taste 13 "Sendertyp" betätigt, worauf das Steuerprogramm einen neuen Datensatz in den Sendertypen-Speicher 16 aufnimmt, dessen Parameter "kleinste Frequenz" und "größte Frequenz" der linken bzw. rechten Grenze des Parameterbereiches 24 entsprechen.

Mit den Beschreibungen der faktisch nicht existierenden Sendertypen HF, V und U kann der Benutzer Aufgaben definieren, mit denen sich jeweils ein ganzes Frequenzband lückenlos vermessen läßt.

Betriebsbeginn

Zu Betriebsbeginn präsentiert das Steuerprogramm 8 einen Bildschirm wie in Fig. 2 und zählt im Fenster "Darstellungen" 21 auf, welche Darstellfenster zur Verfügung stehen, z.B.
- "Sendertypen" zur Auswahl und Anzeige von Sendertypen,
- "Ort" zum Anzeigen des Parameters "Ort",
- "HF-Panorama" zur Anzeige des Parameters "Pegel" in Abhängigkeit des Parameters "Frequenz",
- "Ergebnisdatei" zur Auswahl von Meßwerten, die im Ergebnis-Speicher abgelegt sind.

Klickt der Nutzer in diesem Beispiel nun die Zeile mit dem Namen "Sendertyp" im Fenster "Darstellungen" 21 an, liest das Steuerprogramm 8 den Inhalt des Sendertypen-Speichers 16 und zeigt die Namen der Sendertypen im Darstellfenster "Sendertypen" 22 an.

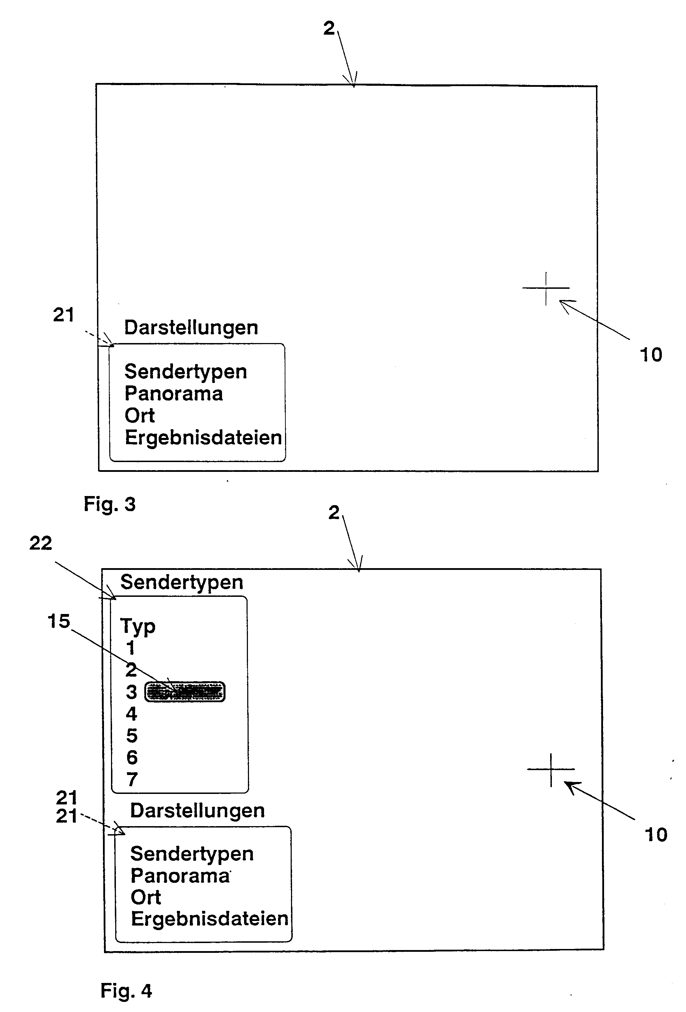

Wählt der Nutzer, wie in Fig. 4 gezeigt, durch Anklicken in diesem Darstellfenster 22 nun den Sendertyp an, den er erfassen will, z.B. den Sendertyp 3, und betätigt die Taste "Meßbereich" 14, erkennt das Steuerprogramm 8, daß der Nutzer den Meßbereich auf diesen Sendertyp eingeschränkt wissen will.

Auswahl des zu erfassenden Sendertyps

Sobald der Benutzer den Meßbereich auf den Sendertyp 3 eingeschränkt hat, liest das Steuerprogramm 8 aus dem Sendertypen-Speicher 16 die erfassbaren Parameter und Parametergrenzen dieses Sendertyps:

```
Meßbare Parameter:
Ort:                                              ja
Frequenz:                                         ja
Pegel:                                            ja
Azimut:                                           ja
Inhalt:                                           ja


Technische Eigenschaften:
untere Betriebsfrequenz:      [MHz]      30
obere Betriebsfrequenz:       [MHz]     .88
kleinster Frequenzschritt:    [kHz]      25
Bandbreiten:                  [kHz]       8
Modulationsarten:                        FM
```

Mit dieser Auswahl sind die Meßbereiche vorgegeben - das Steuerprogramm 8 wird die Frequenzbereiche von 2..29.999 und 88.01...1000 MHz ignorieren, alle Frequenzabstimmungen nur im Kanalraster von 25 kHz vornehmen, diejenigen Zwischenfrequenzfilter wählen, die der Bandbreite von 8 kHz am nächsten kommen und nur den Demodulator für die Modulationsart FM einschalten.

Suche

Welche Parameter der Sender gemessen werden sollen, erkennt das Steuerprogramm 8 anhand aller Darstellfenster, die der Benutzer geöffnet und für die Darstellung aktueller Meßergebnisse aktiviert hat, indem er z.B. den Cursor 10 auf den Rahmen des Fensters positionierte und die Taste "Darstellbereich" 15 betätigte.

Wenn der Benutzer z.B. zunächst nur das Darstellfenster "Panorama" 19 geöffnet und für die Ausgabe von Meßwerten aktiviert hat, erkennt das Steuerprogramm 8 daran, daß die Parameter "Pegel" über "Frequenz" zu messen sind.

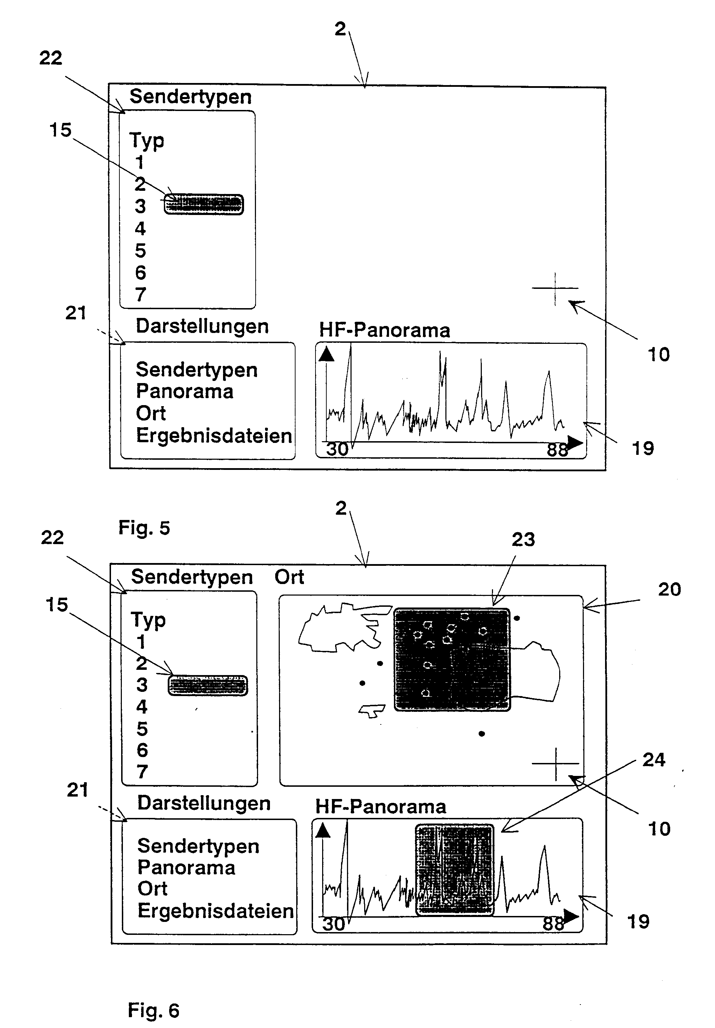

Nach der Öffnung und Aktivierung zeigt ihm das Steuerprogramm 8 die Darstellung 19 wie in Fig. 5 (jedoch noch ohne Meßergebnisse) und skaliert sie auf den aktuell gültigen Meßbereich, der dem des Sendertyps 3 entspricht.

Das Steuerprogramm 8 liest nun aus dem Erfassungsgerätespeicher 17, über welche Geräte es verfügt und sieht, daß sowohl die Peiler (3, 4) als auch der Mithörempfänger 5 den Parameter "Pegel" über "Frequenz" messen können.

Daraufhin wird das Steuerprogramm 8 diesen Frequenzbereich auf die drei Geräte aufteilen und so steuern, daß sie nur diesen Parameter messen.

Die Meßergebnisse der Peiler 3 und 4 sowie des Mithörempfängers 5 legt das Steuerprogramm 8 dann für Analysezwecke im Ergebnis-Speicher 18 ab und stellt sie im HF-Panorama 19 dar wie in Fig 5 gezeigt.

Ortung

Im Beispiel möchte sich der Benutzer nun den Ort von Sendern anzeigen lassen, die in einem Teil-Frequenzbereich senden.

Zur Einschränkung des Frequenzbereiches definiert er mit Hilfe der Cursorsteuerung im "HF-Panorama" 19 einen eingeschränkten Bereich 24 und betätigt die Taste "Meßbereich" 14. Daran erkennt das Steuerprogramm 8, daß der Meßbereich auf diesen Frequenzbereich weiter einzuschränken ist.

Zur Anzeige der Orte öffnet er das Darstellfenster "Ort" 20 und aktiviert es für die Ausgabe aktueller Meßwerte, woran das Steuerprogramm 8 nun erkennt, daß es zusätzlich zum Parameter "Pegel" den Parameter "Ort" bestimmen soll.

Dazu liest es wieder aus dem Erfassungsgeräte-Speicher 17, welche Geräte zur Ermittlung dieses Parameters geeignet sind und erfährt, daß dazu die Peiler 3 und 4 jeweils den Parameter "Azimut" synchron messen müssen und der Mithörempfänger 5 für diese Funktion nicht verwendbar ist.

Weiter liest es, daß zur Ermittlung des Parameters "Azimut" der Parameter "Frequenz" erforderlich ist.

Nun wird das Steuerprogramm 8 die Peiler 3 und 4 den eingeschränkten Frequenzbereich synchron absuchen und alle Peilungen melden lassen, aus diesen die jeweiligen Orte ermitteln und in der Darstellung "Ort" 20 anzeigen.

Da die Darstellung "HF-Panorama" 19 noch immer aktiviert ist, wird das Steuerprogramm 8 die Pegel aller gemessenen Sender in dieser Darstellung anzeigen und auch den Mithörempfänger 5 im eingeschränkten Frequenzbereich weiterhin Signale suchen und Pegel messen lassen.
Die Ergebnisse werden weiterhin im Ergebnis-Speicher 18 abgelegt.

Analyse

Wenn der Nutzer nun die aktuellen Ergebnisse mit älteren vergleichen möchte, braucht er dazu nur das Fenster "Ergebnisdateien" öffnen und das Steuerprogramm 8 präsentiert ihm ein Inhaltsverzeichnis der gespeicherten Ergebnisse.
Aus diesem Speicher kann er nun bestimmte Ergebnisse abrufen, die ihm das Steuerprogramm 8 wie die aktuellen Ergebnisse anzeigt, jedoch so, daß sie von diesen unterscheidbar sind, z.B. durch eine andere Farbe.

Definition eines neuen Sendertyps

Angenommen, der Benutzer hat einen neuen Sendertyp mit eigenen Frequenzbereichen erkannt und will ihn in den Sendertypen-Speicher 16 übernehmen.
Dazu bezeichnet er den Frequenzbereich dieses neuen Sendertyps in der Darstellung "Panorama" 19 wieder mit Cursorsteuerung 11, betätigt die Taste "Sendertyp" 13 und das Steuerprogramm 8 legt einen neuen Datensatz mit diesen Frequenzgrenzen im Sendertypen-Speicher 16 an.

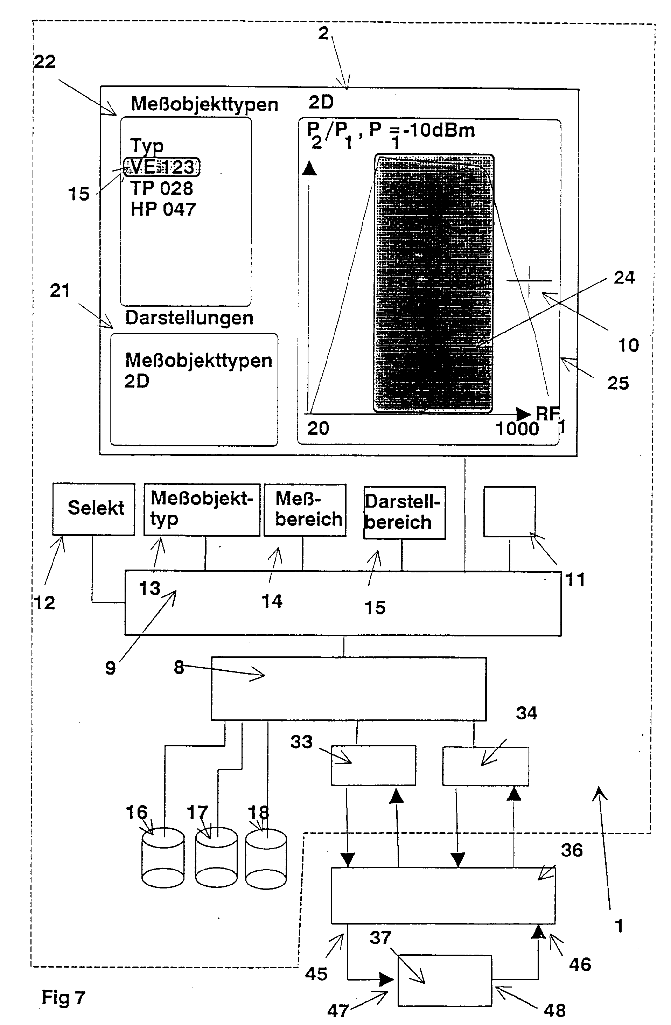

Fig. 7 zeigt die Anwendung der erfindungsgemäßen Einrichtung bei einem elektronischen Meßgerätesystem bestehend aus zwei verschiedenen elektronischen Meßgeräten 33 und 34, die wieder mit dem Steuerrechner 1 funktionsmäßig verknüpft sind und durch diesen ferneinstellbar sind.
Diese Meßgeräte sind mit einer Schaltmatrix 36 verbunden, über welche ein Meßobjekt 37 in vorbestimmter Weise mit diesen Meßgeräten 33 und 34 verbindbar ist. Gleiche Teile des Steuerrechners 1 sind wie im Ausführungsbeispiel nach Fig. 2 mit gleichen Bezugszeichen bezeichnet, im Speicher 17 sind in diesem Fall sämtliche Daten der Meßgeräte 33 und 34 gespeichert, während im Meßobjekttyp-Speicher 16 in diesem Ausführungsbeispiel alle mit dem System meßbaren Meßobjekttypen zusammen mit ihren meßbaren Parametern und den Parametergrenzwerten gespeichert sind. Im Speicher 17 sind beispielsweise gespeichert:

| Meßgerät: | | System | FSAS | UPA |
|---|---|---|---|---|
| Parameter $RF_1$: | | | | |
| min: | [MHz] | 1,00E-5 | 0,10 | 1,00E-5 |
| max: | [MHz] | 1800 | 1800 | 0,10 |
| Geräteanschluss: | | | FSAS-X1 | UPA-X1 |
| dazu erforderliche Parameter: | | | keine | keine |
| Parameter $P_1$: | | | | |
| min: | [dBm] | -100 | -100 | -67 |
| max: | [dBm] | 10 | -5 | 10 |
| Geräteanschluss: | | | FSAS-X1 | UPA-X1 |
| dazu erforderliche Parameter: | | | $RF_1$ | $RF_1$ |
| Parameter $P_2$: | | | | |
| min: | [dBm] | -145 | -145 | -87 |
| max: | [dBm] | 33 | 30 | 33 |
| Geräteanschluss: | | | FSAS-X2 | UPA-X2 |
| dazu erforderliche Parameter: | | | $RF_1$ | keine |
| Parameter $RF_2$: | | | | |
| min: | [MHz] | 1,00E-5 | 0,10 | 8,00E-6 |
| max: | [MHz] | 1800 | 1800 | 0,25 |
| Geräteanschluss: | | | FSAS-X2 | UPA-X2 |
| dazu erforderliche Parameter: | | | $RF_1$ | keine |
| Matrix: | angeschlossenes Gerät: | | Verkabelung: | |
| M-X1 | FSAS-X1 | | fest | |
| M-X2 | FSAS-X2 | | fest | |
| M-X3 | UPA-X1 | | fest | |
| M-X4 | UPA-X2 | | fest | |
| M-X5 (45) | Meßobjekt-Eingang | | d. Benutzer | |
| M-X6 (46) | Meßobjekt-Ausgang | | d. Benutzer | |

Die Handhabung der Benutzeroberfläche für das Meßsystem ist identisch zu der des Funkerfassungssystems.

Eine Darstellung wie z.B. "2D-Grafik" läßt sich aufrufen durch Anklicken des entsprechenden Namens in der Liste, wonach das Steuerprogramm das entsprechende Diagramm präsentiert, jedoch noch ohne Beschriftung der Koordinaten-Achsen.

Die Koordinaten-Achsen lassen sich nun durch den Benutzer beschriften, indem er mit dem Cursor das entsprechende Feld anklickt und einen Meßparameter einträgt oder eine Formel mit Meßparametern. Eine so beschriftete und mit einem neuen Namen versehene Darstellung ist mit ihren Achsen-Beschriftungen abspeicherbar für zukünftige Verwendungen.

### Betriebsbeginn

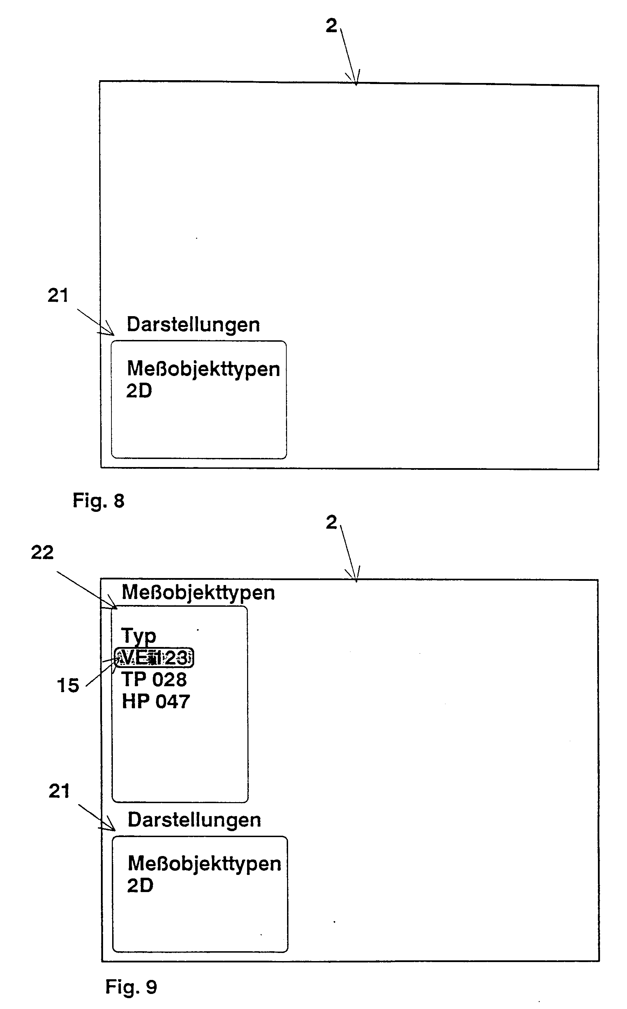

Vor Beginn einer Messung wird dem Benutzer auf dem Bildschirm 2 (Fig. 8) des Rechners 1 eine Tabelle über die möglichen Darstellfenster präsentiert wie
- "Meßobjekttypen", und
- "2D" zur zweidimensionalen Darstellung von 2 Parametern.

### Auswahl des Meßobjekt-Typs

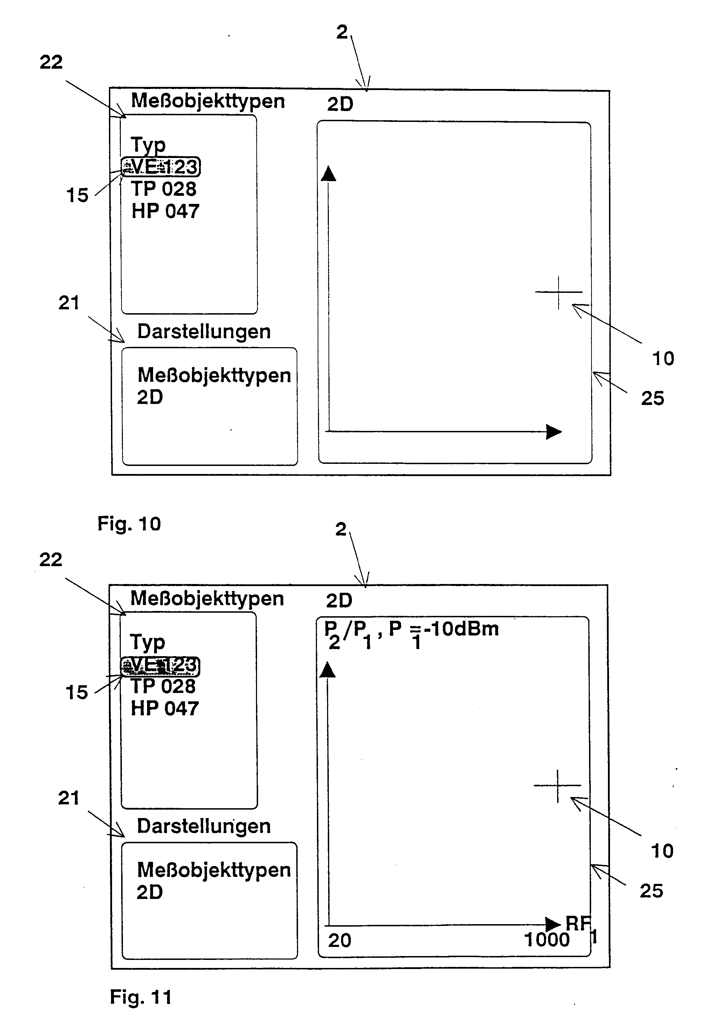

Er klickt in der Tabelle 21 beispielsweise den Namen "Meßobjekttypen" an, woraufhin ihm der Rechner eine Liste aller Meßobjekttypen 22 präsentiert, die im Meßobjekttypen-Speicher 16 beschrieben sind, hier als Beispiel ein Verstärker mit der Typenbezeichnung VE 123, ein Hoch- und ein Tiefpaß mit den Typenbezeichnungen TP 028 bzw. HP 051. (Fig. 9)

Zu den einzelnen Meßobjekttypen enthält der Meßobjekttypen-Speicher 16 folgende Daten, die z.B. aus Herstellerangaben oder anderen Quellen zusammengetragen und in den Meßobjekttypen-Speicher eingegeben worden sind:

```
                                      VE 123    TP 028    HP 047
                           .         Verstärker Tiefpass  Hochpass

            Eingang:                      1         1         1
            Meß- bzw. einstellbare
            Parameter Eingang Meßobjekt:
            P_1min:          [dBm]      -174      -174      -174
            P_1max:          [dBm]         0        10        10
            RF_1min:         [MHz]        20         0         0
            RF_1max:         [MHz]      1000      1000      1000

            Ausgang:                      2         2         2
            Meß- bzw. einstellbare
            Parameter Ausgang Meßobjekt:
            P_2min:          [dBm]      -174         0         0
            P_2max:          [dBm]        20        10        10
            RF_2min:         [MHz]        20         0       100
            RF_2max:         [MHz]      1000        30      1000
```

Beispielsweise klickt der Benutzer nun den Namen "VE 123" in der Liste "Meßobjekttypen" 22 an und das Steuerprogramm liest aus dem Meßobjekttypen-Speicher 16 die technischen Daten dieses Verstärkers.

Mit dieser Auswahl sind die meßbaren Parameter und Meßbereiche vorgegeben sowie, welcher Anschluß der Eingang für Signale und welcher der Ausgang ist:

```
                                    VE 123
                                  Verstärker
             Eingang ist Anschluß:               1
             Meß- bzw. einstellbare
             Parameter Eingang Meßobjekt:
             P1min:              [dBm]        -174
             P1max:              [dBm]           0
             RF1min:             [MHz]          20
             RF1max:             [MHz]        1000
             Ph1min:             [rad]        n.a.
             Ph1max:             [rad]        n.a.


             Ausgang ist Anschluß:              2
             Meß- bzw. einstellbare
             Parameter Ausgang Meßobjekt:
             P2min:              [dBm]        -174
             P2max:              [dBm]          20
             RF2min:             [MHz]          20
             RF2max:             [MHz]        1000
             Ph2min:             [rad]        n.a.
             Ph2max:             [rad]        n.a.
```

Das Steuerprogramm erkennt, daß die Frequenzbereiche von 0..19.9 und oberhalb von 1000 MHz zu ignorieren sind.

Messung

Im Beispiel interessiert sich der Benutzer für das Übertragungsverhalten des Verstärkers, also $P_2/P_1$ in Abhängigkeit von der Frequenz $RF_1$. Es sind mehrere Möglichkeiten denkbar, dies dem Steuerprogramm 8 mitzuteilen, beispielsweise könnte das Steuerprogramm 8 dem Benutzer eine Liste von Darstellfenstern für Parameter anbieten, es könnte ihm auch die Möglichkeit bieten, die Bezeichnungen der darzustellenden Parameter in eine Tabelle zu schreiben, deren Inhalte es anschließend liest, interpretiert und die gewünschten Darstellfenster erzeugt.

In dieser Ausführung ruft der Benutzer ein Darstellfenster "2D" durch Anklicken seines Namens in der Liste 21 auf, woraufhin ihm das Steuerprogramm 8 das Darstellfenster "2D" 26 präsentiert (Fig. 10) und er beschriftet auf übliche Art und Weise die Koordinaten-Achsen:

- die X-Achse mit dem Parameter "$RF_1$",
- die Y-Achse mit mit der Formel "$P_2/P_1$, $P_1$=-10 dBm", die zwei Parameter miteinander verknüpft und einen Parameter auf einen konkreten Wert festlegt, wie in Fig. 11 gezeigt.

Aus der Beschriftung der Koordinatenachsen erkennt das Steuerprogramm nun, daß am Meßobjekt die Parameter $P_2$ und $P_1$ in Abhängigkeit vom Parameter $RF_1$ zu messen und miteinander zu verknüpfen sind.

Zunächst skaliert das Steuerprogramm diese Darstellung auf den Meßbereich 20....1000 MHz, der durch die Wahl des Meßobjekttyps vorbestimmt worden ist.

Nun interessiert sich der Benutzer aber zusätzlich für das Übertragungsverhalten des Verstärkers bis herab zu 0.01 MHz und teilt dies dem System mit, indem er z.B. die Skalierung der X-Achse ändert, so daß sie bei 0.01 MHz beginnt und dazu die Taste "Meßbereich" betätigt.

Das Steuerprogramm liest nun aus dem Meßgeräte-Speicher 17, welches Meßgerät welche Parameter innerhalb welcher Parameter-Grenzen erzeugen bzw. messen kann. Dabei ergibt sich, daß

- der UPA 33 ein Signal mit dem Parameter $P_1$=-10 dBm erzeugt unter der Voraussetzung, daß vorher der Parameter $RF_1$ eingestellt ist. Im Datensatz steht ferner, daß der Parameter $RF_1$ für den UPA auf den Bereich bis 100 kHz beschränkt ist,
- der FSAS 34 ebenfalls ein Signal mit dem Parameter $P_1$=-10 dBm erzeugt, und zwar von 100 kHz bis zur gewünschten Grenze von 1000 MHz.

Aus der Beschreibung für die Matrix 36 liest das Steuerprogramm 8:

```
Meßgerät:                     Matrix
Anschluß              angeschlossenes Gerät        Verkabelung
M-X1                          FSAS-X1                  fest
M-X2                          FSAS-X2                  fest
M-X3                          UPA-X1                   fest
M-X4                          UPA-X2                   fest
M-X5  (45)             Meßobjekt-Eingang  (47)     d. Benutzer
M-X6  (46)             Meßobjekt-Ausgang  (48)     d. Benutzer
```

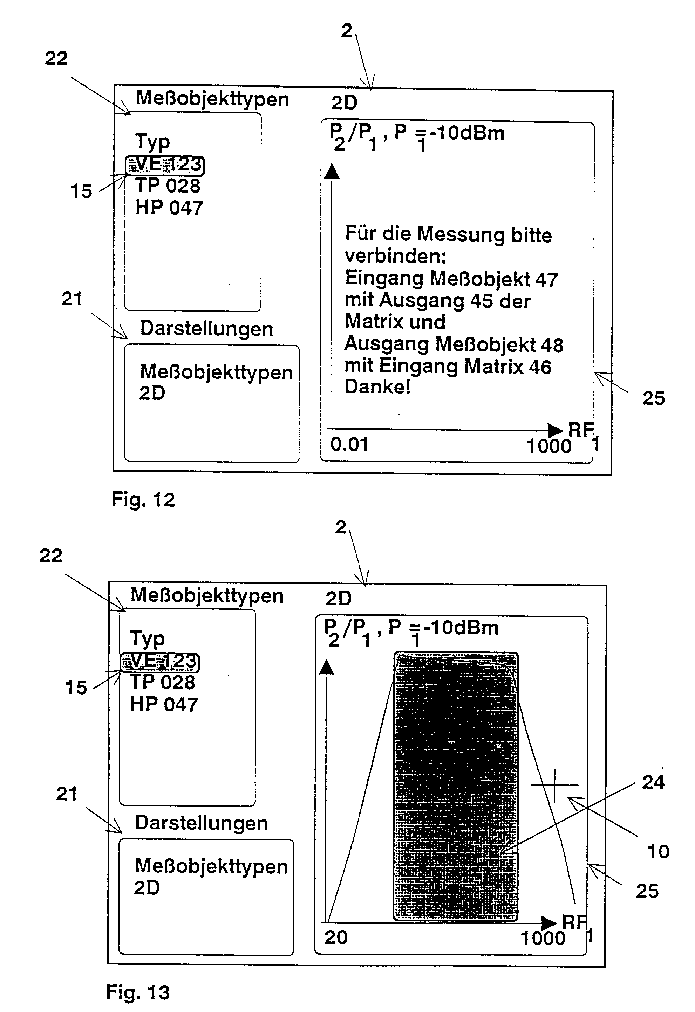

Dabei kann das Steuerprogramm 8 erkennen, daß der Benutzer zwei Verbindungen manuell herstellen muß und bittet ihn aufgrund dieser Informationen, die entsprechenden Verbindungen vorzunehmen, wie in Fig. 12 gezeigt.

Das Steuerprogramm 8 wird für den Beginn der Messung den UPA 33 über die Matrix 36 auf das Meßobjekt 37 schalten und den Frequenzbereich bis 0.1 MHz vermessen, um dann den FSAS 34 anstelle des UPA 33 über die Matrix 36 an das Meßobjekt 37 zu schalten und die Messung bis 1000 MHz fortzuführen.

Die Meßergebnisse legt das Steuerprogramm 8 im Ergebnis-Speicher 18 ab und zeigt sie zugleich in der Darstellung "2D" 25.

Definition eines neuen Meßobjekttyps

Wenn der Benutzer einen Ausschnitt aus einer Darstellung wie z.B. "2D" 25 mit Hilfe des Cursors 10 markiert und die Taste "Meßobjekttyp" 13 betätigt hat, erkennt das Steuerprogramm 8, daß er einen neuen Meßobjekttyp in den Meßobjekttyp-Speicher 16 aufnehmen will und wird es die Parameter, die den Grenzen der Markierung 24 entsprechen, als Parametergrenzen des neuen Typs in den Meßobjekttypen-Speicher 16 übernehmen.

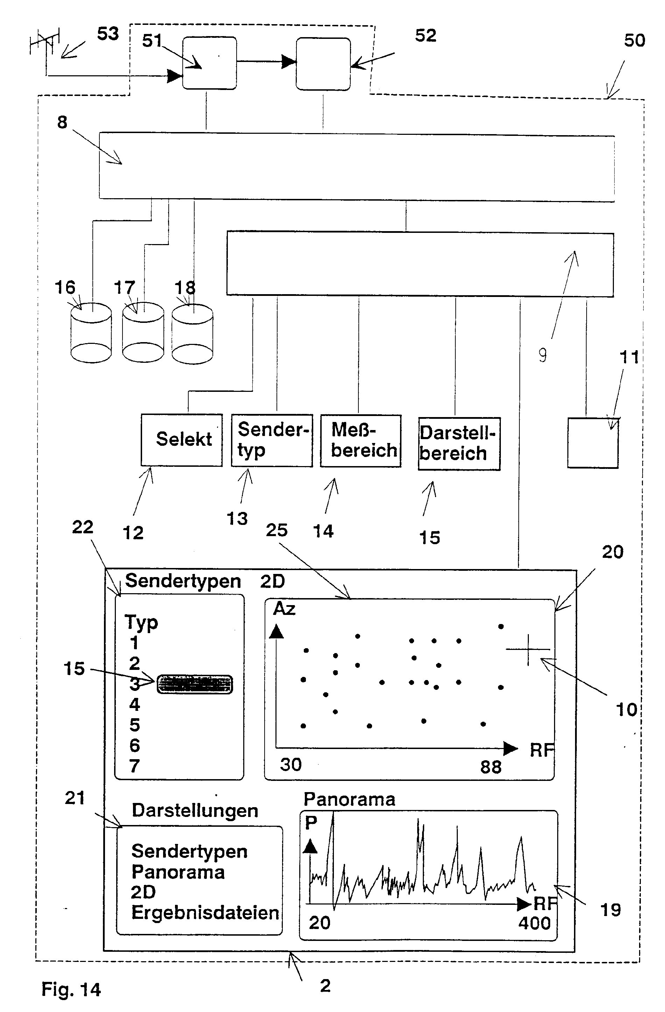

Fig. 14 zeigt einen Peiler 50 mit seinen wesentlichen Baugruppen, einem Empfangsteil 51 und einem Peilzusatz 52. An den Peiler ist eine Antenne 53 anschließbar.

Der Empfangsteil 51 kann in einem Frequenzbereich durchgestimmt werden und Pegel mit einer sehr kurzen Meßzeit messen, während der Peilzusatz 52 lediglich für die Ermittlung von Azimutwerten erforderlich ist, dafür aber eine größere Meßzeit benötigt.

Die Baugruppen 51 und 52 werden von einem Steuerprogramm 8 gesteuert, das mit dem Benutzer über eine übliche Benutzeroberfläche 9 kommuniziert und über drei Speicher verfügt, einen Sendertypen-Speicher 16, einen Baugruppen-Speicher 17 und einen Ergebnisspeicher 18.

Die Inhalte gelangen in diese Speicher auf die gleiche Art wie im Erfassungssystem und können teilweise sogar identisch sein, z.B. die des Sendertypen-Speichers.

Inhalt des Sendertypen-Speichers 16

```
Meßbare Parameter für alle Sendertypen:
Ort:                                    ja
Frequenz:                               ja
Pegel:                                  ja
Azimut:                                 ja
Inhalt:                                 ja
```

| Sendertyp: | Einheit | Typ 1 | Typ 2 | Typ 3 |
|---|---|---|---|---|
| Technische Eigenschaften: | | | | |
| untere Betriebsfrequenz: | [MHz] | 1,50 | 26 | 30 |
| obere Betriebsfrequenz: | [MHz] | 30 | 46 | 88 |
| kleinster Frequenzschritt: | [kHz] | 0,10 | 12,50 | 25 |
| Bandbreiten: | [kHz] | 0,15 | 8 | 8 |
| Modulationsarten: | | AM, USB, LSB | AM, FM | FM, |
| Sendertyp: | | Typ 4 | Typ 5 | Typ 6 |
| Technische Eigenschaften: | | | | |
| untere Betriebsfrequenz: | [MHz] | 88 | 116 | 225 |
| obere Betriebsfrequenz: | [MHz] | 107 | 156 | 400 |
| kleinster Frequenzschritt: | [kHz] | 75 | 12,50 | 25 |
| Bandbreiten: | [kHz] | 75 | 8 | 12 |
| Modulationsarten: | | FM | AM | FM, |
| Sendertyp: | | Typ HF | Typ V | Typ U |
| Technische Eigenschaften: | | | | |
| untere Betriebsfrequenz: | [MHz] | 2 | 30 | 200 |
| obere Betriebsfrequenz: | [MHz] | 30 | 200 | 1000 |
| kleinster Frequenzschritt: | [kHz] | 0,10 | 12,50 | 12,50 |
| Bandbreiten: | [kHz] | 0,10 | 12,50 | 12,50 |
| Modulationsarten: | | alle | alle | alle |

Inhalt des Baugruppen-Speichers 17

| Baugruppe: | | Peiler | Empfangs-teil | Peil-zusatz |
|---|---|---|---|---|
| Parameter Frequenz: | | | | |
| kleinste Frequenz: | [MHz] | | 20 | |
| größte Frequenz: | [MHz] | | 200 | |
| kleinste Auflösung: | [kHz] | | 1 | |
| maximale Einstellzeit: | [s] | | 1,00E-3 | |
| Bandbreiten: | [kHz] | | 7,50 | |
| | | | 15 | |
| | | | 150 | |
| dazu erforderliche Parameter: | | | keine | |
| Parameter Pegel: | | | | |
| Modulationsarten: | | | alle | |
| Meßzeit: | [s] | | 2,00E-3 | |
| dazu erforderliche Parameter: | | | Frequenz | |
| Parameter Azimut: | | | | |
| Modulationsarten: | | | | alle |
| Meßzeit: | [s] | | | 0,01 |
| dazu erforderliche Parameter: | | | | Frequenz |

Aus dieser Beschreibung ist zu lesen, daß für die Pegelmessung nur 2 ms, für die Peilung aber 10 ms Meßzeit erforderlich sind.

Auch das Steuerprogramm des Peilers 50 bietet seinem Nutzer nach Betriebsbeginn zunächst die Liste 21 der möglichen Darstellungen, aus der sich der Nutzer z.B. die Sendertypen-Liste 22, die 2D-Darstellung 25 und das Panorama 19 auswählt.

Die Koordinaten-Achsen der 2D-Darstellung 25 beschriftet er mit den Parametern "Az" für Azimut und "RF", während die Koordinaten-Achsen des Panoramas 19 bereits beschriftet sind. Sobald der Nutzer den Cursor 10 auf den Rahmen der beiden Darstellfenster 19 und 20 positioniert und die Taste "Darstellbereich" 15 betätigt hat, erkennt das Steuerprogramm 8, daß die Parameter Azimut und Pegel über den Parameter RF zu messen und darzustellen sind.

Wenn der Nutzer einen Sendertyp aus der Liste der Sendertypen 22 ausgewählt und dazu die Taste "Meßbereich" 14 betätigt hat, wird das Steuerprogramm 8 alle Darstellungen auf die Parametergrenzen dieses Sendertyps skalieren.

Im Beispiel skaliert der Nutzer die Darstellung Panorama 19 neu, indem er die Parametergrenzen 20 und 400 MHz einträgt und jeweils die Taste "Meßbereich" 14 betätigt.

Daraus erkennt das Steuerprogramm 8 nun, daß von 20 bis 30 MHz der Pegel zu messen ist, von 30 bis 88 MHz Pegel und Azimut und von 88 bis 400 MHz wieder nur der Pegel.

Aus dem Baugruppen-Speicher 17 liest das Steuerprogramm 8 nun, welche Parameter durch welche Baugruppen gemessen werden können und erfährt, daß der Empfangsteil 51 den Pegel über den gesamten Frequenzbereich mit einer Meßzeit von 2 ms je Frequenz von messen kann, und daß der Peilzusatz eine Meßzeit von 10 ms benötigt.

Dementsprechend wird das Steuerprogramm 8 den Empfangsteil 51 bei 20 MHz mit der Pegelmessung beginnen lassen, 2 ms je Schritt, und ab 30 MHz die Meßzeit auf 10 ms verlängern und vom Peilzusatz 52 zusätzlich den Azimutwert einholen.

Ab 88 MHz wird das Steuerprogramm 8 die Meßzeiten wieder auf 2 ms je Frequenzschritt reduzieren.

**Patentansprüche**

1. Einrichtung zum Einstellen von einzelnen unterschiedlichen elektronischen Geräten (3 bis 5; 33, 34; 50, 51, 52) eines Gerätesystems zum Messen oder Erfassen der Eigenschaften eines ausgewählten Objekts, mit einem Steuerrechner (1), und einem diesem zugeordneten Geräte-Speicher (17), in welchem die einzelnen Geräte (3 bis 5; 33, 34; 50, 51, 52) des Systems mit ihren technischen Eigenschaften und ihren einstellbaren Funktionen gespeichert sind **gekennzeichnet** durch einen dem Steuerrechner (1) zugeordneten Objekt-Speicher (16), in welchem die verschiedenen Objekttypen mit ihren Eigenschaften gespeichert sind, wobei mittels des Steuerrechners (1) vor Durchführung einer Objekt-Messung bzw. -Erfassung auf dem Bildschirm (2) des Steuerrechners (1) zunächst sämtliche Objekttypen mit ihren Eigenschaften und außerdem die möglichen Darstellungsarten dieser Objekt-Eigenschaften darstellbar und daraus vom Benutzer der zu messende bzw. zu erfassende Objekttyp und dessen gewünschte Darstellungsart(en) der Eigenschaften auswählbar sind, und der Steuerrechner (1) derart mit den einzelnen Geräten (3 bis 5; 33, 34; 50, 51, 52) funktionsmäßig verbunden ist, daß nach Auswahl des interessierenden Objekttyps und der gewünschten Darstellungsart(en) über den Steuerrechner (1) automatisch die hierfür geeigneten Geräte (3 bis 5; 33, 34; 50, 51, 52) des Systems auswählbar und an diesen die hierfür erforderlichen Einstellungen durchführbar sind und anschließend die gewünschte Messung oder Erfassung ausführbar ist.

2. Einrichtung nach Anspruch 1, dadurch **gekennzeichnet,** daß nach Auswahl des gewünschten Objekttyps und der gewünschten Darstellungsart(en) diese ausgewählte(n) Darstellungsart(en) mit den speziellen Grenzwerten des ausgewählten Objekttyps auf dem Bildschirm (2) darstellbar sind und diese Grenzwerte vom Benutzer entsprechend der gewünschten Meß- oder Erfassungs-Aufgabe abänderbar sind, und über den Steuerrechner (1) erst dann die hierfür geeigneten Geräte (3 bis 5; 33, 34; 50, 51, 52) des Systems auswählbar und einstellbar sind.

3. Einrichtung nach Anspruch 1 oder 2 zum Einstellen eines aus mehreren unterschiedlichen elektronischen Funkerfassungsgeräten (3 bis 5; 50, 51, 52) bestehenden Funkerfassungssystems auf mindestens einen ausgewählten Sender, dadurch **gekennzeichnet,** daß im Gerätespeicher (17) die einzelnen Funkerfassungsgeräte des Systems mit ihren technischen Eigenschaften und ihren einstellbaren Funkerfassungsfunktionen und im Objekt-Speicher (16) die verschiedenen mit dem System erfaßbaren Sendertypen mit ihren erfaßbaren Eigenschaften gespeichert sind und der Steuerrechner (1) so ausgebildet ist, daß vor Beginn einer Funkerfassung auf dem Bildschirm (2) zunächst sämtliche gespeicherten Sendertypen mit ihren verschiedenen erfaßbaren Eigenschaften zusammen mit ihren möglichen Darstellungsart(en) darstellbar und daraus vom Benutzer der zu erfassende Sendertyp und die davon interessierenden Parameter und Darstellungsart(en) auswählbar sind,

**12**

und der Steuerrechner (1) mit den einzelnen Erfassungsgeräten (3 bis 5; 50, 51, 52) funktionsmäßig derart verbunden ist, daß nach Auswahl des interessierenden Sendertyps und dessen Darstellungsart(en) über den Steuerrechner (1) automatisch die hierfür geeigneten Erfassungsgeräte des Systems auswählbar und an ihnen die hierfür erforderlichen Einstellungen durchführbar sind und anschließend die gewünschte Funkerfassung des ausgewählten Senders ausführbar ist.

4. Einrichtung nach Anspruch 1 oder 2 zum Einstellen eines aus mehreren unterschiedlichen elektronischen Meßgeräten (33, 34) bestehenden Meßsystems auf ein ausgewähltes Meßobjekt, dadurch **gekennzeichnet,** daß im Gerätespeicher (17) die einzelnen Meßgeräte (33, 34) des Systems mit ihren technischen Eigenschaften und ihren einstellbaren Meßfunktionen und im Objektspeicher (16) die verschiedenen mit dem Meßsystem meßbaren Meßobjekt-Typen (37) mit ihren meßbaren Parametern gespeichert und der Steuerrechner (1) so ausgebildet ist, daß vor Beginn einer Messung auf dem Bildschirm (2) zunächst sämtliche gespeicherten Meßobjekt-Typen (37) mit ihren meßbaren Parametern zusammen mit deren Darstellungsarten darstellbar und daraus vom Benutzer nicht nur der ihn interessierende Meßobjekt-Typ (37), sondern auch die ihn davon interessierende(n) Darstellungsart(en) auswählbar sind,
und der Steuerrechner (1) mit den einzelnen Meßgeräten (33, 34) funktionsmäßig so verbunden ist, daß nach Auswahl des interessierenden Meßobjektes (37) und dessen Darstellungsart(en) über den Steuerrechner (1) automatisch die hierfür geeigneten Meßgeräte (33, 34) des Systems auswählbar, und an ihnen die erforderlichen Einstellungen durchführbar sind und anschließend die gewünschte Messung an dem mit den Meßgeräten (33, 34) verbundenen ausgewählten Meßobjekt (37) ausführbar ist.

5. Einrichtung nach Anspruch 4, dadurch **gekennzeichnet,** daß die Meßgeräte-Ein- und Ausgänge mit einer Schaltmatrix (36) verbunden sind, an die das Meßobjekt (37) anschließbar ist und die durch den Steuerrechner (1) entsprechend der erforderlichen Verbindung zwischen Meßobjekt (37) und Meßgeräten (33, 34) steuerbar ist.

6. Einrichtung nach einem der vorhergehenden Ansprüche, dadurch **gekennzeichnet,** daß die elektronischen Geräte (3 bis 5; 33, 34; 50, 51, 52) über eingebaute Fernbedienungseinrichtungen mit dem Steuerrechner (1) verbunden sind.

## Claims

1. Facility for adjusting individual different electronic instruments (3 to 5; 33, 34; 50, 51, 52) belonging to an instrument system for measuring or detecting the characteristics of a selected target, featuring a master computer (1) and associated therewith an instruments memory (17) in which the individual instruments (3 to 5; 33, 34; 50, 51, 52) belonging to the system are stored with their technical characteristics and their adjustable functions,
characterised by a target memory (16) associated with the master computer (1) and in which the various target types are stored along with their characteristics, and by means of the master computer (1) prior to carrying out target measurement or target detection it is possible on the screen (2) of the master computer (1) to display firstly all the target types with their characteristics and in addition the possible display modes of these target characteristics, and from this the user can select the target type to be measured or detected and thereof the desired display mode(s) of the characteristics, and the master computer (1) is functionally connected to the individual instruments (3 to 5; 33, 34; 50, 51, 52) in such a manner that following selection of the target type that is of interest and of the desired display mode(s), via the master computer (1) the instruments (3 to 5; 33, 34; 50, 51, 52) of the system that are suitable therefor can automatically be selected and on said instruments the requisite adjustments can be carried out and afterwards the desired measurement or detection can be performed.

2. Facility according to claim 1, characterised in that following selection of the desired target type and of the desired display mode(s) this or these selected display mode(s) with the specific limiting values of the selected target type can be displayed on the screen (2) and these limiting values can be modified by the user according to the desired measurement or detection task, and via the master computer (1) only then can the instruments (3 to 5; 33, 34; 50, 51, 52) of the system that are suitable therefor be selected and adjusted.

3. Facility according to claim 1 or 2 for adjusting a radio detection system consisting of a plurality of different electronic radio detection instruments (3 to 5; 50, 51, 52) to at least one selected transmitter, characterised in that the individual radio detection instruments of the system are stored with their technical characteristics and their adjustable radio detection functions in the instruments memory (17), and the various transmitter types that can be detected with the system are stored with their detectable characteristics in the target memory (16), and the master computer (1) is so designed that before the start of radio detection all stored transmitter types with their various detectable characteristics together with their possible display mode(s) can first of all be displayed on the screen (2) and from this the user can select the transmitter type to be detected and the parameters and display mode(s) thereof that are of interest,

and the master computer (1) is functionally connected to the individual detection instruments (3 to 5; 50, 51, 52) in such a manner that following selection of the transmitter type of interest and of the display mode(s) thereof the master computer (1) can be used to automatically select the detection instruments of the system that are suitable therefor and on said instruments the requisite adjustments can be carried out and afterwards the desired radio detection of the selected transmitter can be performed.

4. Facility according to claim 1 or 2 for adjusting a measurement system consisting of a plurality of different electronic measuring instruments (33, 34) to a selected measurement target/device under test (D.U.T.), characterised in that the individual measuring instruments (33, 34) of the system are stored with their technical characteristics and their adjustable measurement functions in the instruments memory (17), and the various D.U.T. types (37) measurable with the measurement system are stored with their measurable parameters in the target memory (16), and the master computer (1) is so designed that before the start of a measurement all stored D.U.T. types (37) with their measurable parameters together with the display modes thereof can first of all be displayed on the screen (2) and from this the user is able to select not only the D.U.T. type (37) of interest to him but also the display mode(s) thereof that is/are of interest to him,

and the master computer (1) is functionally connected to the individual measuring instruments (33, 34) in such a way that following selection of the measurement target/D.U.T. (37) of interest and of the display mode(s) thereof, the master computer (1) can be used to automatically select the measuring instruments (33, 34) of the system that are suitable therefor, and on said instruments the necessary adjustments can be carried out and afterwards the desired measurement can be performed on the selected D.U.T. (37) connected to the measuring instruments (33, 34).

5. Facility according to claim 4, characterised in that the inputs and outputs of the measuring instruments are connected to a switch matrix (36) to which the measurement target/D.U.T. (37) can be wired and which is adapted to be controlled by the master computer (1) in conformity with the necessary connection between the measurement target/D.U.T. (37) and the measuring instruments (33, 34).

6. Facility according to any of the preceding claims, characterised in that the electronic instruments (3 to 5; 33, 34; 50, 51, 52) are connected to the master computer (1) via built-in remote-control devices.

**Revendications**

1. Installation pour régler les appareils électroniques séparés, différents (3 à 5 ; 33, 34 ; 50, 51, 52) d'un système d'appareils de mesure et de détection des caractéristiques d'un objet sélectionné, comprenant un calculateur de commande (1) auquel est associée une mémoire d'appareil (17) contenant les différents appareils (3 à 5; 33, 34 ; 50, 51, 52) du système et leurs caractéristiques techniques ainsi que leurs fonctions réglables, caractérisée par une mémoire d'objet (16) associée au calculateur de commande (1) et qui contient les différents types d'objets et leurs caractéristiques, tandis qu'à l'aide du calculateur de commande (1), avant d'exécuter une mesure ou une détection d'objets sur l'écran (2) du calculateur de commande (1), on affiche tout d'abord tous les types d'objets et leurs caractéristiques et, en outre, les modes d'affichage possibles de ces caractéristiques des objets, et, à partir de là, l'utilisateur sélectionne le type d'objet à détecter ou à mesurer ainsi que le ou les modes d'affichage des caractéristiques, et le calculateur de commande (1) est ainsi relié fonctionnellement aux différents appareils (3 à 5 ; 33, 34 ; 50, 51, 52) et, après la sélection du type d'objet intéressant et du ou des types d'affichage souhaités, le calculateur de commande (1) sélectionne automatiquement les appareils appropriés pour cela (3 à 5 ; 33, 34 ; 50, 51, 52) du système et exécute sur ceux-ci les réglages nécessaires puis exécute les mesures ou détections souhaitées.

2. Installation selon la revendication 1, caractérisée en ce qu'après la sélection du type d'objet souhaité et du ou des modes d'affichage souhaités, ce ou ces types d'affichage souhaités apparaissent avec les valeurs limites particulières du type d'objet sélectionné sur l'écran (2), et ces valeurs limites peuvent être modifiées par l'utilisateur en fonction du problème souhaité de mesure ou de saisie, et le calculateur de commande (1) sélectionne et règle les appareils appropriés (3 à 5, 33, 34; 50, 51, 52) du système.

3. Installation selon la revendication 1 ou 2 pour régler un système d'interception radio composé de plusieurs appareils d'interception radio électroniques différents (3 à 5, 50, 51, 52) pour au moins un émetteur choisi, caractérisée en ce que, dans la mémoire d'appareil (17), on enregistre les différents appareils d'interception radio du système avec leurs caractéristiques techniques et les fonctions d'interception radio réglables et, dans la mémoire objet (16), on enregistre les différents types d'émetteurs que peut détecter le système avec leurs caractéristiques susceptibles d'être détectées, et le calculateur de commande (1) est réalisé pour qu'avant le début d'une interception radio, il affiche tout d'abord sur l'écran image (2) tous les types d'émetteurs en mémoire avec leurs différentes caractéristiques susceptibles d'être détectées, et les modes d'affichage possibles, parmi lesquels l'utilisateur sélectionne le type d'émetteur à détecter et les paramètres qui l'intéressent ainsi que le ou les modes d'affichage,

et le calculateur de commande (1) est relié fonctionnellement aux différents appareils de détection (3 à 5 ; 51, 52, 53) pour qu'après la sélection du type d'émetteur intéressant et de son mode d'affichage, le calculateur de commande (1) sélectionne automatiquement les appareils de détection appropriés et y effectue les réglages nécessaires puis exécute l'interception radio souhaitée de l'émetteur choisi.

4. Installation selon la revendication 1 ou 2 pour régler un système de mesure composé d'un ou plusieurs appareils électroniques de mesure (33, 34) différents sur un objet de mesure sélectionné, caractérisée en ce que, dans la mémoire d'appareil (17), on inscrit les différents appareils de mesure (33, 34) du système avec leurs caractéristiques techniques et leurs fonctions de mesure réglables et, dans la mémoire d'objet (16), on enregistre les différents types d'objets de mesure (37) que peut mesurer le système ainsi que leurs paramètres mesurables, et le calculateur de commande (1) est conçu pour qu'avant le début d'une mesure, il affiche tout d'abord sur l'écran (2) tous les types d'objets de mesure enregistrés (37) et leurs paramètres mesurables avec les modes d'affichage, et l'utilisateur peut sélectionner non seulement le type d'objet de mesure (37) qui l'intéresse mais également le ou les modes d'affichage et les paramètres qui l'intéressent,

et le calculateur de commande (1) est relié fonctionnellement aux différents appareils de mesure (33, 34) et, après la sélection de l'objet de mesure intéressant (37) et de son ou ses modes d'affichage, le calculateur de commande (1) sélectionne automatiquement les appareils de mesure (33, 34) du système, qui sont appropriés pour cela, et y effectue les réglages nécessaires puis exécute les mesures souhaitées à l'aide des appareils de mesure (33, 34) sur les objets de mesure (37) sélectionnés.

5. Installation selon la revendication 4, caractérisée en ce que les appareils de mesure comportent les entrées et sorties reliées à une matrice de commutation (36) à laquelle peut se raccorder l'objet de mesure (37), et le calculateur de commande (1) commande la liaison nécessaire entre l'objet de mesure (37) et les appareils de mesure (33, 34).

6. Installation selon l'une des revendications précédentes, caractérisée en ce que les appareils électroniques (3 à 5 ; 33, 34 ; 50, 51, 52) sont reliés au calculateur de commande (1) par des installations de télécommande intégrées.

Fig 1

**Sendertypen   Ort**

22

Typ
1
2
15 → 3
4
5
6
7

2

23

20

24

15

10

21   **Darstellungen**

Sendertypen
Panorama
Ort
Ergebnisdateien

**HF-Panorama**

30                              88

19

| Selekt | Sender-typ | Meß-bereich | Darstell-bereich | |
|---|---|---|---|---|

11

12   13   ·14   15

9

8

1

16   17   18   3   4   5

Fig 2

**2**

**21**

Darstellungen

Sendertypen
Panorama
Ort
Ergebnisdateien

**10**

Fig. 3

**2**

**22**

Sendertypen

**15**

Typ
1
2
3
4
5
6
7

**21**
**21**

Darstellungen

Sendertypen
Panorama
Ort
Ergebnisdateien

**10**

Fig. 4

**2**

**22** Sendertypen

**15** Typ
1
2
3
4
5
6
7

**21** Darstellungen

Sendertypen
Panorama
Ort
Ergebnisdateien

HF-Panorama

30                                                88

**10**

**19**

Fig. 5

**22** Sendertypen    Ort

**15** Typ
1
2
3
4
5
6
7

**21** Darstellungen

Sendertypen
Panorama
Ort
Ergebnisdateien

HF-Panorama

30                                                88

**2**

**23**

**20**

**24**

**10**

**19**

Fig. 6

Fig 7

2

21

Darstellungen

Meßobjekttypen
2D

**Fig. 8**

2

22

Meßobjekttypen

Typ
VE 123
TP 028
HP 047

15

21

Darstellungen

Meßobjekttypen
2D

**Fig. 9**

**Fig. 10**

**Fig. 11**

22

Meßobjekttypen      2D

Typ
VE 123
15   TP 028
HP 047

$P_2/P_1$ , $P_1$ =-10dBm

21   Darstellungen

Meßobjekttypen
2D

Für die Messung bitte
verbinden:
Eingang Meßobjekt 47
mit Ausgang 45 der
Matrix und
Ausgang Meßobjekt 48
mit Eingang Matrix 46
Danke!

25

0.01                    1000  RF₁

Fig. 12

2

22

Meßobjekttypen      2D

Typ
VE 123
15   TP 028
HP 047

$P_2/P_1$ , $P_1$ =-10dBm

21   Darstellungen

Meßobjekttypen
2D

24

10

25

20                      1000  RF₁

Fig. 13

23

Fig. 14